# FASCICULE DE BREVET EUROPEEN

(11) **EP 3 696 981 B1**
(45) Date de publication et mention de la délivrance du brevet: **02.06.2021**
(21) Numéro de dépôt: 20157244.3
(22) Date de dépôt: 13.02.2020
(51) Int. Cl.: H03K 17/18, H03K 17/082

(54) **CELLULE DE RELAIS STATIQUE DE SÉCURITÉ ET ENSEMBLE DE CELLULES DE RELAIS STATIQUE ASSOCIÉ**
ZELLE EINES STATISCHEN SICHERHEITSRELAIS UND GESAMTHEIT VON ZELLEN EINES SOLCHEN STATISCHEN RELAIS
STATIC RELAY SECURITY CELL AND ASSOCIATED STATIC RELAY CELL ASSEMBLY

(30) Priorité: 15.02.2019 FR 1901551
(43) Date de publication de la demande: 19.08.2020
(73) Titulaire: ALSTOM Transport Technologies, 93400 Saint-Ouen (FR)
(72) Inventeur: LAMARCHE, Damien, 69003 Lyon (FR); BLERIOT, Quentin, 69007 Lyon (FR); MENAND, Denis, 01800 Mollon (FR); BERT, Jean-Claude, 69420 Condrieu (FR)
(74) Mandataire: Lavoix

(56) Documents cités:
- WO-A1-2010/070209
- US-A- 4 757 417

## Description

La présente invention concerne une cellule de relais statique de sécurité du type comprenant une borne d'entrée et une borne de sortie, au moins un interrupteur principal en série entre la borne d'entrée et la borne de sortie, et une unité de contrôle configurée pour commander indépendamment le ou chaque interrupteur principal.

L'invention s'applique au domaine des systèmes électroniques de sécurité, en particulier aux systèmes électroniques de sécurité pour la signalisation ferroviaire.

Les relais statiques sont utilisés dans les systèmes électroniques de sécurité en tant qu'interrupteurs de sortie. Ce sont des dispositifs de commutation réalisés, notamment avec des composants électroniques à base de semi-conducteurs. Ces relais sont dits statiques car ils ne comportent pas de composants mécaniques ou électromécaniques. Ils permettent de contrôler le passage d'un courant d'intensité élevée avec un signal de commande de faible puissance.

L'avantage de tels relais statique est la durabilité des composants utilisés, ceux-ci pouvant supporter un plus grand nombre de commutation que des relais électromécaniques de sécurité. Ceux-ci génèrent aussi moins de chaleur et leur vitesse d'ouverture est plus facilement contrôlable.

Habituellement ces relais statiques comprennent des interrupteurs, tels que des interrupteurs à base de transistor, comme par exemple des transistors à effet de champ à grille isolée (MOSFET).

Le document CN 105946902 décrit une sortie utilisant des signaux de commande dynamique pour piloter via deux unités de commande des interrupteurs, tels que des transistors.

Cependant, en utilisant de tels composants, les transistors soumis à une forte tension peuvent, même à l'état bloqué, laisser passer un faible courant, dû à l'usure ou aux dysfonctionnements des composants à semi-conducteur. Au-delà d'une certaine valeur, une charge pourrait être pilotée à tort, entraînant un problème de sécurité.

Le document US 4 757 417 A décrit une cellule de relais statique comportant un détecteur de présence ou d'absence de courant de fuite basé sur un photo-coupleur.

L'invention a pour but de proposer une cellule de relais statique de sécurité et un ensemble de cellules de relais statique associé permettant de détecter une usure ou une défaillance des interrupteurs qui le compose. La cellule de relais statique de sécurité et l'ensemble de cellules de relais statique associé doivent pouvoir continuer d'assurer leur fonction de coupure, même en cas de panne d'un composant.

A cet effet, l'invention a pour objet une cellule de relais statique, selon la revendication 1.

Une telle cellule de relais statique permet de détecter la présence d'un courant de fuite à travers les interrupteurs qui la compose.

Suivant certains modes de réalisation, la cellule de relais statique est selon l'une des revendications 2 à 7.

L'invention a aussi pour objet un ensemble de cellules de relais statique, selon la revendication 8.

Suivant certains modes de réalisation, l'ensemble de cellules de relais statique est selon la revendication 9.

Ces caractéristiques et avantages de l'invention apparaîtront à la lecture de la description qui va suivre, donnée uniquement à titre d'exemple non limitatif, et faite en référence aux dessins annexés sur lesquels :
- [Fig 1] la figure 1 est une représentation schématique d'un ensemble de cellules de relais statique selon l'invention, comprenant deux cellules de relais statique de sécurité en série,
- [Fig 2] la figure 2 est une représentation schématique d'une cellule de relais statique de sécurité de la figure 1, comprenant notamment deux interrupteurs principaux en série entre une borne d'entrée et une borne de sortie, un détecteur de courant de fuite, et pour chaque interrupteur, un module de commande,
- [Fig 3] la figure 3 est un graphique représentant un exemple d'évolution temporelle des valeurs d'un signal de comparaison et de signaux de détection de courant de fuite, suivant différents cas de fonctionnement de la cellule de la figure 2, et
- [Fig 4] la figure 4 est une représentation schématique d'une variante de l'ensemble de cellules de relais statique de la figure 1.

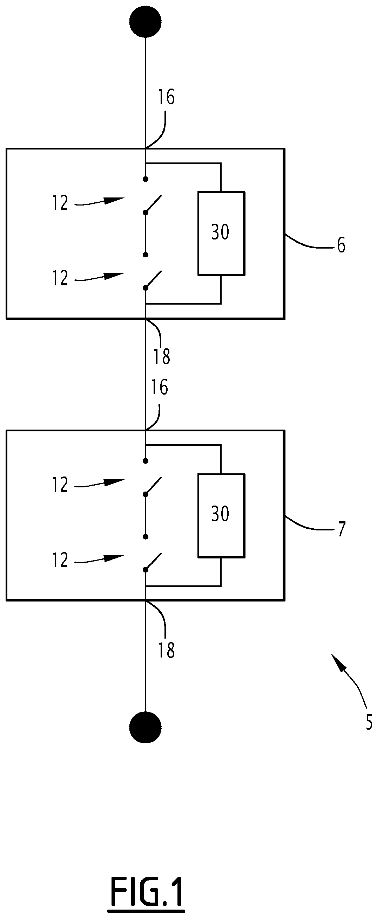

La figure 1 présente un ensemble 5 de cellules de relais statique comprenant une première cellule 6 et une deuxième cellule 7 de relais statique de sécurité, de préférence identiques, en série. Chacune des cellules 6 et 7 comprend une borne d'entrée 16 et une borne de sortie 18, la borne de sortie 18 de la cellule 6 étant connectée à la borne d'entrée 16 de la cellule 7. Chaque cellule 6, 7 comprend deux interrupteurs 12 principaux connectés en série entre sa borne d'entrée 16 et sa borne de sortie 18.

En variante, chaque cellule 6, 7 comprend un seul interrupteur 12 connecté entre la borne d'entrée 16 et la borne de sortie 18.

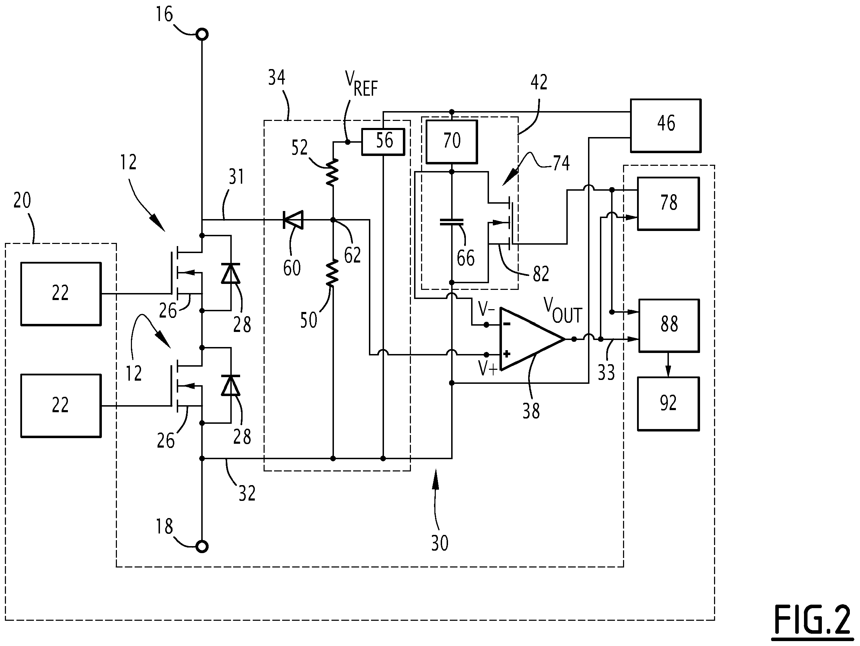

L'architecture d'une cellule 6 ou 7 de relais statique de sécurité est décrite dans ce qui suit, en regard de la figure 2.

La cellule 6 est apte à faire circuler un courant I de la borne d'entrée 16 vers la borne de sortie 18, lorsque les interrupteurs 12 sont en position fermée.

Par la suite, toutes les tensions sont prises en référence au potentiel de la borne de sortie 18.

Les interrupteurs 12 sont chacun contrôlés indépendamment par une unité de contrôle (commande et relecture) 20 propre également avantageusement à récupérer l'état de l'interrupteur parmi un état fermé et un état ouvert. Plus précisément, pour chaque interrupteur 12, l'unité de contrôle (commande et relecture) 20 comprend un module de commande 22 configuré pour générer et transmettre à l'interrupteur 12 correspondant un signal de commande de la commutation de l'interrupteur 12. Avantageusement, chaque signal de commande est un signal dynamique.

Chaque interrupteur 12 comprend avantageusement un transistor 26 et une diode 28 connectée en antiparallèle du transistor 26. Les transistors 26 sont par exemple, des transistors à effet de champ, de préférence des transistors à effet de champ à grille isolée. Dans ce cas, le drain d'un premier transistor 26 est connecté à la borne d'entrée 16, sa source est connectée au drain du second transistor 26, et la source du second transistor 26 est connectée à la borne de sortie 18. Pour chaque transistor 26, le module de commande 22 correspondant est connecté au transistor 26 par sa grille.

En outre, la cellule 6 comprend un détecteur 30 de courant de fuite comportant deux entrées 31 et 32 connectées aux bornes de l'ensemble des deux interrupteurs 12 et une sortie 33 connectée à l'unité de contrôle (commande et relecture) 20. Le détecteur 30 est apte à détecter un potentiel courant de fuite circulant dans les interrupteurs 12, notamment lorsqu'au moins un des interrupteurs 12 est en position ouverte.

Le détecteur 30 comporte un module de mesure 34 comprenant deux entrées connectées aux entrées 31 et 32 du détecteur 30 et une sortie. Il est propre à fournir en sortie une tension de fuite V₊, la tension de fuite V₊ étant représentative du courant de fuite.

Le détecteur 30 comporte en outre un comparateur 38 comprenant deux entrées et une sortie. Il est connectée par une de ses entrées à la sortie du module de mesure 34 et par sa sortie à la sortie 33 du détecteur 30.

Le détecteur 30 comporte en outre un générateur 42 de signal périodique de tension de comparaison connecté à l'autre entrée du comparateur 38. Le générateur 42 est commandé par l'unité de contrôle (commande et relecture) 20. Il est propre à générer et à fournir par une sortie, au comparateur 38 un signal de comparaison V₋, le signal de comparaison V₋ étant un signal périodique de tension.

Dans l'exemple de la figure 2, le détecteur 30 comporte une alimentation isolée 46 connectée au module de mesure 34 et au générateur 42 et propre à alimenter électriquement ces derniers.

En variante non représentée, le détecteur 30 comporte deux alimentations isolées, l'une étant connectée au module de mesure 34, l'autre étant connectée au générateur 42.

Par exemple, le module de mesure 34 est un pont diviseur de tension comprenant deux résistances 50 et 52 connectées en série entre l'une des entrées du module de mesure 34 et une source de tension continue 56, et une diode 60 connectée entre un nœud 62 entre les résistances 50 et 52, et l'autre entrée du module de mesure 34. Le nœud 62 est connecté à la sortie du module de mesure 34.

La source de tension continue 56 est alimentée par l'alimentation 46 et est propre à fournir une tension de référence V_{REF}.

La diode 60 est orientée de façon à ce qu'elle soit en régime bloqué lorsque les interrupteurs 12 sont fermés et que le courant I est d'intensité positive.

Le générateur 42 est par exemple un générateur de signal en dent de scie, le signal de comparaison V₋ généré étant un signal en dent de scie. Il comprend un condensateur 66 connecté à une source de courant continu 70, et un interrupteur 74 secondaire connecté en parallèle au condensateur.

La source de courant continu 70 est alimentée par l'alimentation 46 et est apte à charger le condensateur 66 avec un courant continu. La borne du condensateur 66 chargée positivement est connectée à la sortie du générateur 42.

L'unité de contrôle (commande et relecture) 20 est configurée pour contrôler la commutation de l'interrupteur 74. Plus précisément, l'unité de contrôle (commande et relecture) 20 comprend un module 78 de commande du générateur 42, configuré pour générer et transmettre à l'interrupteur 74 un signal de commande de décharge V_{DC}.

L'interrupteur 74 comprend par exemple un transistor 82 à effet de champ, de préférence un transistor à effet de champ à grille isolée. Dans ce cas, le drain et la source du transistor 82 sont placés de façon à court-circuiter le condensateur 66 afin de provoquer la décharge du condensateur 66, lorsque le transistor 82 est passant, et la grille du transistor 82 est connectée au module 78.

Le comparateur 38 est propre à comparer la valeur de la tension de fuite V₊ et la valeur du signal de comparaison V₋, et à donner en sortie un signal de détection de courant de fuite V_{OUT} ayant un rapport cyclique α représentatif du courant de fuite.

L'unité de commande 20 est apte à récupérer le signal de détection de courant de fuite V_{OUT} à la sortie 33 du détecteur 30. Plus précisément, l'unité de contrôle (commande et relecture) 20 comprend un module de réception 88 connecté à la sortie 33 du détecteur 30 et apte à récupérer le signal de détection de courant de fuite V_{OUT}.

En complément, le module 78 est connecté à la sortie 33 du détecteur 30 et est apte à récupérer le signal de détection de courant de fuite V_{OUT}.

Le module de réception 88 est connecté au module 78 et est apte à récupérer le signal de commande de décharge V_{DC}.

L'unité de contrôle (commande et relecture) 20 comprend en outre un module de calcul 92 connecté au module de réception 88 et configuré pour calculer le rapport cyclique α du signal de détection de courant de fuite V_{OUT}, la valeur du rapport cyclique α étant représentative du courant de fuite, ainsi que le rapport cyclique du signal de commande de décharge V_{DC}. Il est en outre, apte à mémoriser les rapports cycliques calculés, et à effectuer un vote sur différentes valeurs de rapport cyclique calculées.

On appelle rapport cyclique le rapport entre le temps où le signal est en état haut sur une période et le temps total d'une période.

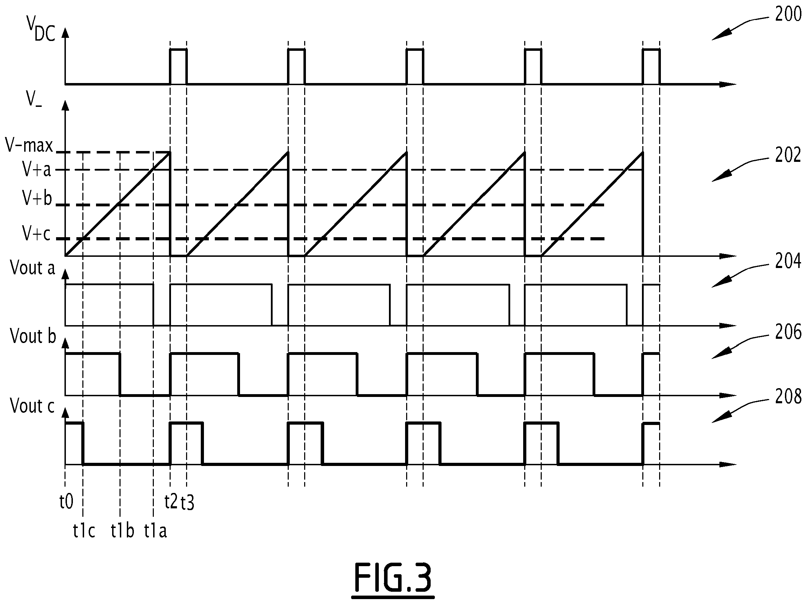

Le fonctionnement de la cellule 6 est à présent décrit à l'aide de la figure 3 représentant un exemple d'évolution temporelle du signal de commande de décharge V_{DC} sur le graphique 200, du signal de comparaison V₋ sur le graphique 202, et du signal de détection de courant de fuite V_{OUT} pour trois cas de fonctionnement respectivement sur les graphiques 204, 206 et 208.

La cellule 6 comprend habituellement deux états de fonctionnement : un état fermé lorsque les deux interrupteurs 12 sont fermés et que le courant I circule de la borne d'entrée 16 à la borne d'entrée 18, et un état ouvert lorsqu'au moins un des interrupteurs 12 est ouvert.

Le graphique 200 représente l'évolution temporelle du signal de commande de décharge V_{DC} généré par le module 78. Il commande, lorsqu'il est en état haut, la fermeture de l'interrupteur 74 et la décharge du condensateur 66. Le signal de commande de décharge V_{DC} est un signal périodique d'une période t₃-t₀. Sur la première période, il est en état haut entre des instants temporels t₂ et t₃.

Dans ce qui suit, on s'intéresse au comportement de la cellule 6 sur la première période, c'est-à-dire, entre un instant initial t₀ et l'instant t₃, le comportement étant identique sur les autres périodes.

Le graphique 202 représente l'évolution temporelle du signal de comparaison V₋ généré par le générateur 42. A l'instant initial t₀, le condensateur est déchargé et la valeur du signal de comparaison V₋ est nulle. Jusqu'à l'instant t₂, la source de courant 70 charge le condensateur 66 avec un courant d'intensité constante et la valeur du signal de comparaison V₋ croît linéairement avec une pente qui est fonction de l'intensité du courant généré par la source de courant 70 et de la capacité électrique du condensateur 66, jusqu'à atteindre une valeur V₋ₘₐₓ à l'instant t₂. A l'instant t₂, le module 78 commande la fermeture de l'interrupteur 74, ce qui amorce la décharge du condensateur 66, et la valeur du signal de comparaison V₋ est alors nulle entre les instants t₂ et t₃.

Le graphique 202 présente aussi en pointillés des valeurs de la tension de fuite V₊ pour différents cas de fonctionnement. La tension de fuite V₊ prend une valeur V₊ₐ dans un cas a où les deux interrupteurs 12 sont ouverts et que l'on n'observe pas de courant de fuite. Elle prend une valeur V_{+c} dans un cas c où les deux interrupteurs 12 sont fermés. Elle prend une valeur V_{+b} dans un cas b où un des interrupteurs 12 est fermé et où l'autre est ouvert et observe un courant de fuite, ou alors où les deux interrupteurs 12 sont ouverts et observent tous deux un courant de fuite.

Les graphiques 204, 206 et 208 représentent l'évolution temporelle de signaux respectifs V_{OUTa}, V_{OUTb} et V_{OUTc} correspondant au signal de détection de courant de fuite V_{OUT} pour les cas respectifs a, b et c. Le signal V_{OUTa}, ou respectivement V_{OUTb} ou V_{OUTc}, est en état haut lorsque la tension de fuite V₊ est supérieure à la valeur du signal de comparaison V₋, c'est-à-dire entre l'instant t₀ et un instant t₁ₐ, ou respectivement t_{1b} ou t_{1c}, ainsi qu'entre l'instant t₂ et l'instant t₃, et en état bas dans le cas contraire, c'est-à-dire entre les instants t₁ₐ, ou respectivement t_{1b} ou t_{1c}, et t₂.

Pour détecter qu'un interrupteur 12 est défectueux et laisse passer un courant de fuite, l'unité de contrôle (commande et relecture) 20 commute un des interrupteurs 12 à l'état ouvert et l'autre à l'état fermé, l'interrupteur 12 à l'état ouvert étant celui qui est testé. Le module de réception 88 récupère alors le signal de détection de courant de fuite V_{OUT} et calcule son rapport cyclique α_{b}. Il effectue la même opération pour tester l'autre interrupteur 12.

Le module de calcul 92 calcule alors les rapports cycliques α_{b} correspondant à ces deux tests. Les rapports cycliques α_{b} calculés pour chacun des interrupteurs 12 testés sont comparés à des rapports cycliques calculés et mémorisés par le module de calcul 92 lorsque les deux interrupteurs 12 sont ouverts αₐ et fermés α_{c} et au rapport cyclique du signal de commande de décharge V_{DC}, afin de détecter un potentiel courant de fuite, notamment lorsqu'un des rapports cycliques α_{b} est plus faible que αₐ.

Avantageusement, le module de réception 88 récupère le signal de commande de décharge V_{DC}, afin de vérifier que le signal est correctement généré.

En cas de panne d'un des interrupteurs 12 d'une cellule 6, celui-ci est laissé non commandé par l'unité de contrôle (commande et relecture) 20 et notamment fermé, et le changement d'état de la cellule 6 est assuré uniquement par l'autre interrupteur 12.

On comprend alors qu'une cellule 6 comprenant deux interrupteurs 12 permet d'avoir une sûreté de fonctionnement plus élevée qu'une cellule 6 comprenant un seul interrupteur 12.

En cas de panne d'un des deux interrupteurs 12, la cellule 6 est considérée en panne.

L'ensemble 5 est dans un état fermé lorsque les cellules 6 et 7 sont à l'état fermé, et dans un état ouvert lorsqu'au moins une des cellules 6 et 7 est à l'état ouvert.

Lorsqu'une des cellules de l'ensemble 5est en panne, elle est laissée à l'état fermé et l'ouverture et la fermeture de l'architecture composite 5 est assurée par l'autre cellule de l'ensemble 5. Une opération de maintenance sur la cellule défaillante sera alors lancée.

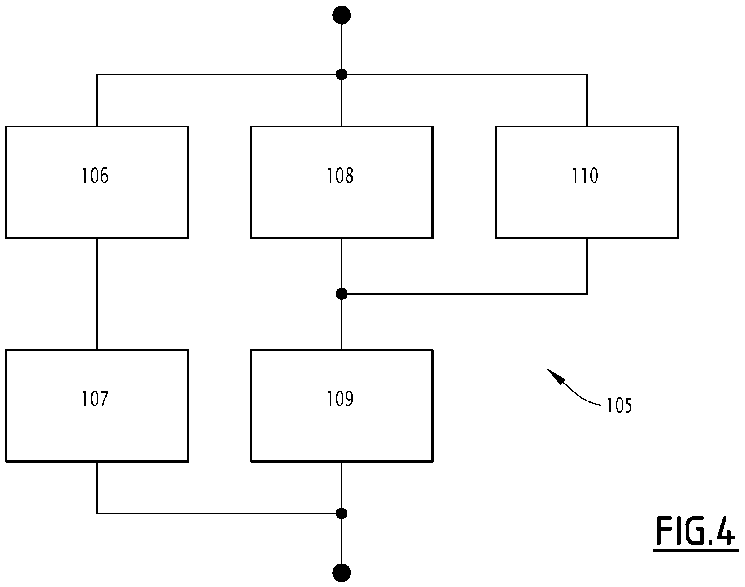

La figure 4 présente un autre mode de réalisation de l'ensemble 105 de cellules de relais statique comprenant une première cellule 106, une deuxième cellule 107, une troisième cellule 108, une quatrième cellule 109 et une cinquième cellule 110 de relais statique de sécurité.

Chacune des cellules 106 à 110 comprend une borne d'entrée et une borne de sortie. Les première et deuxième cellules 106 et 107 sont connectées de la même façon que les première et deuxième cellules 6 et 7 de l'ensemble 5. La borne d'entrée de la première cellule 106 est en outre connectée aux bornes d'entrée de la troisième cellule 108 et de la cinquième cellule 110, la borne de sortie de la troisième cellule 108 est connectée à la borne de sortie de la cinquième cellule 110 et à la borne d'entrée de la quatrième cellule 109, et la borne de sortie de la deuxième cellule 107 est connectée à la borne de sortie de la quatrième 109.

L'ensemble 105 est dans un état fermé lorsque les cellules 106 et 107 sont fermées, ou lorsque la cellule 109 et au moins une des cellules 108 et 110 sont fermées. Elle est dans un état ouvert lorsqu'au moins une des cellules 106 et 107 est ouverte, et que la cellule 109 ou les cellules 108 et 110 sont ouvertes.

Ainsi, en cas de panne d'une des cellules 106 à 110, elle est laissée à l'état fermé, et l'ouverture et la fermeture de l'ensemble 105 peut être assurée par les autres cellules.

On comprend alors que le mode de réalisation de l'ensemble 105 permet d'avoir une disponibilité plus élevée que le mode de réalisation de l'architecture composite 5. En effet l'ensemble 105 peut permettre d'assurer la sureté de fonctionnement même en cas de panne de 2 voire même 3 cellules, tant que 2 cellules en série ne sont pas en panne simultanément.

## Revendications

1. Cellule (6) de relais statique comprenant :
- une borne d'entrée (16) et une borne de sortie (18),
- au moins un interrupteur (12) principal en série entre la borne d'entrée (16) et la borne de sortie (18), et
- une unité de contrôle (20) configurée pour commander indépendamment le ou chaque interrupteur (12) principal,
**caractérisée en ce qu'**elle comprend un détecteur (30) de courant de fuite, apte à détecter un courant de fuite dans le ou chaque interrupteur (12) principal,
le détecteur (30) de courant de fuite comprenant :
- un module de mesure (34) d'une tension de fuite (V₊), la tension de fuite (V₊) étant représentative du courant de fuite,
- un générateur (42) de signal périodique de tension, propre à générer un signal de comparaison (V₋), et
- un comparateur (38) propre à comparer la valeur de la tension de fuite (V₊) et la valeur du signal de comparaison (V₋), et à donner en sortie un signal de détection de courant de fuite (V_{OUT}) ayant un rapport cyclique (α) représentatif du courant de fuite.

2. Cellule (6) selon la revendication 1, dans laquelle l'unité de contrôle (20) comprend un module de réception (88) relié en sortie du comparateur (38) pour recevoir le signal de détection de courant de fuite (V_{OUT}), et un module de calcul (92) propre à calculer le rapport cyclique (α) du signal de détection de courant de fuite (V_{OUT}).

3. Cellule (6) selon la revendication 1 ou 2, dans laquelle le générateur (42) de signal périodique est un générateur de signal en dents de scie, le signal de comparaison (V₋) généré étant un signal en dents de scie.

4. Cellule (6) selon la revendication 3, dans laquelle le générateur (42) de signal périodique comprend une source de courant continu (70), un condensateur (66) et un interrupteur (74) secondaire, la source de courant continu (70) étant apte à charger le condensateur (66), l'interrupteur (74) secondaire étant apte à court-circuiter le condensateur (66) lorsqu'il est en position fermée afin de provoquer la décharge du condensateur (66), et étant commandé par un signal de commande de décharge (V_{DC}) transmis par l'unité de contrôle (20).

5. Cellule (6) selon l'une quelconque des revendications 1 à 4, dans laquelle le module de mesure (34) de la tension de fuite (V₊) comprend un pont diviseur de tension (50, 52), le module de mesure étant connecté aux bornes de l'interrupteur principal ou de l'ensemble des interrupteurs principaux.

6. Cellule (6) selon l'une quelconque des revendications précédentes, dans laquelle la cellule (6) comprend au moins deux interrupteurs (12) principaux en série.

7. Cellule (6) selon l'une quelconque des revendications précédentes, dans laquelle chaque interrupteur (12) principal comporte un transistor (26) et une diode (28) connectée en antiparallèle du transistor (26), et dans lequel au moins un transistor (26) est un transistor à effet de champ, de préférence un transistor à effet de champ à grille isolée.

8. Ensemble (5, 105) de cellules de relais statique **caractérisé en ce qu'**il comprend une première cellule (6, 106) et une deuxième cellule (7, 107) de relais statique en série, chaque cellule étant selon l'une quelconque des revendications précédentes, dans lequel la borne de sortie (18) de la première cellule (6, 106) est connectée à la borne d'entrée (16) de la deuxième cellule (7, 107), les unités de contrôle (20) de chaque cellule étant apte à communiquer entre elles.

9. Ensemble (5, 105) de cellules de relais statique selon la revendication 8, comprenant en outre une troisième cellule (108), une quatrième cellule (109) et une cinquième cellule (110) de relais statique, chaque cellule étant selon l'une quelconque des revendications 1 à 7, dans lequel :
- la borne d'entrée (16) de la première cellule (6, 106) est connectée aux bornes d'entrée (16) de la troisième cellule (108) et de la cinquième cellule (110),
- la borne de sortie (18) de la troisième cellule (108) est connectée à la borne de sortie (18) de la cinquième cellule (110) et à la borne d'entrée (16) de la quatrième cellule (109), et
- la borne de sortie (18) de la deuxième cellule (7, 107) est connectée à la borne de sortie (18) de la quatrième cellule (109),
les unités de contrôle (20) de chaque cellule étant apte à communiquer entre elles.

## Patentansprüche

1. Zelle (6) für ein statisches Relais, welche aufweist:
- eine Eingangsklemme (16) und eine Ausgangsklemme (18),
- zumindest einen Hauptunterbrecher (12), welcher in Reihe zwischen der Eingangsklemme (16) und der Ausgangsklemme (18) ist, und
- eine Einheit zur Steuerung (20), welche eingerichtet ist, um den oder jeden Hauptunterbrecher (12) unabhängig zu steuern,
**dadurch gekennzeichnet, dass** sie einen Detektor (30) für einen Leckstrom aufweist, welcher geeignet ist, um einen Leckstrom in dem oder jedem Hauptunterbrecher (12) zu detektieren,
wobei der Detektor (30) für den Leckstrom aufweist:
- ein Modul zum Messen (34) einer Leckspannung (V₊), wobei die Leckspannung (V₊) repräsentativ für den Leckstrom ist,
- einen Generator (42) für ein periodisches Spannungssignal, welcher imstande ist, ein Vergleichssignal (V₋) zu erzeugen, und
- einen Komparator (38), welcher imstande ist, den Wert der Leckspannung (V₊) und den Wert des Vergleichssignals (V₋) zu vergleichen und am Ausgang ein Leckstrom-Detektionssignal (V_{OUT}) auszugeben, welches ein Tastverhältnis (α) hat, welches repräsentativ für den Leckstrom ist.

2. Zelle (6) gemäß Anspruch 1, wobei die Einheit zur Steuerung (20) aufweist ein Modul zum Empfangen (88), welches mit dem Ausgang des Komparators (38) verbunden ist, um das Leckstrom-Detektionssignal (V_{OUT}) zu empfangen, und ein Modul zum Berechnen (92), welches imstande ist, das Tastverhältnis (a) des Leckstrom-Detektionssignals (V_{OUT}) zu berechnen.

3. Zelle (6) gemäß Anspruch 1 oder 2, wobei der Generator (42) für das periodische Signal ein Sägezahnsignal-Generator ist, wobei das erzeugte Vergleichssignal (V₋) ein Sägezahnsignal ist.

4. Zelle (6) gemäß Anspruch 3, wobei der Generator (42) für das periodische Signal aufweist eine Gleichstrom-Quelle (70), einen Kondensator (66) und einen Sekundärunterbrecher (74), wobei die Gleichstrom-Quelle (70) geeignet ist, um den Kondensator (66) aufzuladen, wobei der Sekundärunterbrecher (74) geeignet ist, um den Kondensator (66) kurzzuschließen, wenn er in der Geschlossen-Position ist, um das Entladen des Kondensators (66) zu bewirken, und mittels eines Steuersignals zum Entladen (V_{DC}) gesteuert wird, welches mittels der Einheit zur Steuerung (20) übertragen wird.

5. Zelle (6) gemäß irgendeinem der Ansprüche 1 bis 4, wobei das Modul zum Messen (34) der Leckspannung (V₊) eine Spannungsteilerbrücke (50, 52) aufweist, wobei das Modul zum Messen mit den Klemmen des Hauptunterbrechers oder der Gruppe der Hauptunterbrecher verbunden ist.

6. Zelle (6) gemäß irgendeinem der vorherigen Ansprüche, wobei die Zelle (6) zumindest zwei Hauptunterbrecher (12) in Reihe aufweist.

7. Zelle (6) gemäß irgendeinem der vorherigen Ansprüche, wobei jeder Hauptunterbrecher (12) einen Transistor (26) und eine Diode (28), welche antiparallel zum Transistor (26) geschaltet ist, aufweist, und wobei zumindest ein Transistor (26) ein Feldeffekt-Transistor ist, vorzugsweise ein Feldeffekt-Transistor mit isoliertem Gate.

8. Gruppe (5, 105) von Zellen für ein statisches Relais, **dadurch gekennzeichnet, dass** sie eine erste Zelle (6, 106) und eine zweite Zelle (7, 107) für ein statisches Relais in Reihe aufweist, wobei jede Zelle gemäß irgendeinem der vorherigen Ansprüche ist, wobei die Ausgangsklemme (18) der ersten Zelle (6, 106) mit der Eingangsklamme (16) der zweiten Zelle (7, 107) verbunden ist, wobei die Einheiten zur Steuerung (20) jeder Zelle geeignet sind, um miteinander zu kommunizieren.

9. Gruppe (5, 105) von Zellen für ein statisches Relais gemäß Anspruch 8, welche ferner eine dritte Zelle (108), eine vierte Zelle (109) und eine fünfte Zelle (110) für ein statisches Relais aufweist, wobei jede Zelle gemäß irgendeinem der Ansprüche 1 bis 7 ist, wobei:
- die Eingangsklemme (16) der ersten Zelle (6, 106) mit den Eingangsklemmen (16) der dritten Zelle (108) und der fünften Zelle (110) verbunden ist,
- die Ausgangsklemme (18) der dritten Zelle (108) mit der Ausgangsklamme (18) der fünften Zelle (110) und mit der Eingangsklamme (16) der vierten Zelle (109) verbunden ist, und
- die Ausgangsklemme (18) der zweiten Zelle (7, 107) mit der Ausgangsklemme (18) der vierten Zelle (109) verbunden ist,
wobei die Einheiten zur Steuerung (20) jeder Zelle geeignet sind, um miteinander zu kommunizieren.

## Claims

1. A static relay cell (6) comprising:
- an input terminal (16) and an output terminal (18),
- at least one main switch (12) in series between the input terminal (16) and the output terminal (18), and
- a control unit (20) configured to control the or each main switch independently (12),
**characterized in that** it comprises a leakage current detector (30), able to detect a leakage current in the or each main switch (12),
the leakage current detector (30) comprising:
- a measuring module (34) for measuring a leakage voltage (V₊), the leakage voltage (V₊) being representative of the leakage current,
- a periodic voltage signal generator (42), able to generate a comparison signal (V₋), and
- a comparator (38) able to compare the value of the leakage voltage (V₊) and the value of the comparison signal (V₋), and to give, as output, a leakage current detection signal (V_{OUT}) having a duty factor (α) representative of the leakage current.

2. The cell (6) according to claim 1, wherein the control unit (20) comprises a reception module (88) coupled at its output to the comparator (38) in order to receive the leakage current detection signal (V_{OUT}), and a computing module (92) able to compute the duty factor (α) of the leakage current detection signal (V_{OUT}).

3. The cell (6) according to claim 1 or 2, wherein the periodic signal generator (42) is a sawtooth signal generator, the generated comparison signal (V₋) being a sawtooth signal.

4. The cell (6) according to claim 3, wherein the periodic signal generator (42) comprises a DC current source (70), a capacitor (66) and a secondary switch (74), the DC current source (70) being able to charge the capacitor (66), the secondary switch (74) being able to short-circuit the capacitor (66) when it is in the closed position in order to cause the discharge of the capacitor (66), and being controlled by a discharge control signal (V_{DC}) transmitted by the control unit (20).

5. The cell (6) according to any one of claims 1 to 4, wherein the module (34) for measuring the leakage voltage (V₊) comprises a voltage divider bridge (50, 52), the measuring module being connected to the terminals of the main switch or of the assembly of the main switches.

6. The cell (6) according to any one of the preceding claims, wherein the cell (6) comprises at least two main switches (12) in series.

7. The cell (6) according to any one of the preceding claims, wherein each main switch (12) includes a transistor (26) and a diode (28) connected in antiparallel with the transistor (26), and wherein at least one transistor (26) is a field-effect transistor, preferably an insulated-gate field-effect transistor.

8. An assembly (5, 105) of static relay cells, **characterized in that** it comprises a first static relay cell (6, 106) and a second static relay cell (7, 107) in series, each cell being according to any one of the preceding claims, wherein the output terminal (18) of the first cell (6, 106) is connected to the input terminal (16) of the second cell (7, 107), the control units (20) of each cell being able to communicate with one another.

9. The assembly (5, 105) of static relay cells according to claim 8, further comprising a third static relay cell (108), a fourth static relay cell (109) and a fifth static relay cell (110), each cell being according to any one of claims 1 to 7, wherein:
- the input terminal (16) of the first cell (6, 106) is connected to the input terminals (16) of the third cell (108) and the fifth cell (110),
- the output terminal (18) of the third cell (108) is connected to the output terminal (18) of the fifth cell (110) and the input terminal (16) of the fourth cell (109), and
- the output terminal (18) of the second cell (7, 107) is connected to the output terminal (18) of the fourth cell (109),
the control units (20) of each cell being able to communicate with one another.
